# EUROPEAN PATENT APPLICATION

(11) **EP 2 374 570 A2**
(43) Date of publication of application: **12.10.2011**
(21) Application number: 11160581.2
(22) Date of filing: 31.03.2011
(51) Int. Cl.: B23K 26/34, B23K 26/14

(54) **Metal deposition method and laser metal deposition apparatus**

(30) Priority: 01.04.2010 JP 2010084769
(71) Applicant: Hitachi Ltd., Tokyo 100-8280 (JP)
(72) Inventor: Kawanaka, Hirotsugu, Tokyo 100-8220 (JP); Tsukamoto, Takeshi, Tokyo 100-8220 (JP); Miyagi, Masanori, Tokyo 100-8220 (JP)
(74) Representative: Beetz & Partner

(57) **Abstract**

In a deposition method of forming a buildup on a single crystal or directionally solidified crystal parent material, metal deposition is performed from an extension in a preferential growth orientation of parent material crystals while forcedly cooling a portion of the parent material somewhat below a processed surface and beforehand giving a temperature gradient to the parent material so that a maximum temperature gradient is oriented along the preferential growth orientation of parent material crystals.

## Description

### Background of the Invention

The present invention relates to a metal deposition method of forming a buildup in buildup welding for alloy products with a crystal orientation thereof controlled, while controlling solidification so as to make a crystal growth orientation of the buildup the same as a solidification crystal orientation of a base material alloy and a laser metal deposition apparatus used therefor.

Large stresses are applied to buckets (blades) of a turbine, a jet engine, etc by centrifugal forces. Therefore, there are used buckets formed from directionally solidified alloys and single crystal alloys, of which a crystal orientation is in a direction, in which centrifugal forces act. Directionally solidified alloy buckets and single crystal alloy buckets suffer oxidation reduced thickness, crack, etc. when used in high temperature and high load environments over a long term. Also, casting defects are generated at the time of manufacture in some cases. Such defects are conventionally repaired by means of brazing, TIG welding, plasma welding, and the like. When conventional repair welding methods are applied to directionally solidified alloy buckets and single crystal alloy buckets, crystals in a repaired portion are not the same in orientation as those of a base material. When crystal orientation differs, decrease in strength on a repaired portion becomes a problem.

Therefore, it is proposed to make repairs by cutting out a damaged portion so that a surface, from which defects are cut out, orients in a preferential crystal growth orientation of a base material, then adding a filler metal and irradiating a laser beam in a relatively low power density over a relatively long term so as to make a beam diameter on an irradiated surface relatively large to thereby create a molten pool having a small ratio of depth to width (JP-A-9-110596). Likewise, it is proposed to make repairs while cutting out a damaged portion, adding a filler metal and heating a base material by means of a heating torch (JP-A-2001-269784). Also, there is proposed a method of controlling a heat input and a heating pattern so that a ratio of a solidification rate (R) in a molten repaired portion and a temperature gradient (G) on a molten boundary becomes at least a value of 3x10⁴ °C· sec/cm², at which directionally solidified crystals are generated (JP-A-2003-48053). Besides, as repair methods for buildup welding, there are a half-overlap method (JP-A-2008-264841), a method of laminating a second layer between beads of a first layer, which are built up with an interval (JP-A-2005-152918), and the like.

The aforementioned repair method of controlling a solidification structure of a repaired portion is effective in repair, in which a base material is molten. In case of forming a buildup in these methods so as to make a crystal orientation of a buildup the same as that of a parent material, however, it is difficult to control so that a maximum temperature gradient is oriented along a preferential growth orientation of parent material crystals, thus heightening a possibility of generation of crystals having different crystal orientations. Such tendency is marked as a buildup is increased in height.

Also, with the repair methods in the aforementioned prior documents, in the case where a lower layer portion and a higher layer portion of a buildup are processed under the same conditions, the higher layer portion varies greatly in temperature gradient as compared with the case of processing the lower layer portion and so such change in characteristics as an increase of dendrite crystals in width or the like becomes a problem.

### Summary of the Invention

It is an object of the invention to provide a metal deposition method of forming a buildup, a crystal orientation of which is the same as that of crystals of a parent material, on the parent material of a single crystal or directionally solidified crystals and an apparatus used therefor.

Metal deposition method of the invention has a feature in that in a deposition method of forming a buildup on a single crystal or directionally solidified crystal parent material, the method comprising setting a processed surface into up side, cooling by means of cooling means a portion on a parent material side with respect to the processed surface, and depositing a metal from an extension in a preferential growth orientation of parent material crystals while beforehand giving a temperature gradient to the parent material side so that a maximum temperature gradient is oriented along the preferential growth orientation of parent material crystals.

Also, a laser metal deposition apparatus of the invention has a feature in that a deposition apparatus of forming a buildup on a single crystal or directionally solidified crystal parent material comprises a laser head for laser irradiation, a processing head provided with a nozzle for supplying of a filler metal and a nozzle for supplying of shielding gases, and cooling means for forcedly cooling a parent material side.

According to the invention, it is possible to form a buildup, a crystal orientation of which is the same as that of parent material crystals, on a single crystal or directionally solidified crystal parent material.

The object of forming a buildup, a growth orientation of which is the same as that of parent material crystals, on a single crystal or directionally solidified crystal parent material is realized by a construction comprising a processing head provided with a filler metal feeding mechanism, by which metal deposition is performed from an extension in a preferential growth orientation of parent material crystals, a heat source irradiating mechanism and a shielding gas mechanism, and a cooling mechanism, which forcedly cools a portion of the parent material somewhat below a processed surface thereof to beforehand give a temperature gradient to the parent material so that a maximum temperature gradient is oriented along the preferential growth orientation of parent material crystals.

An object of forming a buildup, a growth orientation of which is the same as that of parent material crystals, in the case where the buildup is increased in height is realized by a construction comprising a processing head provided with a filler metal feeding mechanism, by which metal deposition is performed from an extension in a preferential growth orientation of parent material crystals, a heat source irradiating mechanism and a shielding gas mechanism, and a cooling mechanism, which forcedly cools a portion somewhat below a processed portion to beforehand give a temperature gradient to the parent material so that a maximum temperature gradient is oriented along the preferential growth orientation of parent material crystals.

First, the metal deposition method of the invention has an advantage that when a molten portion of a welded buildup solidifies in processing, it is possible to obtain a direction of maximum temperature gradient in a preferential growth orientation of parent material crystals. This leads to an advantage that control can be performed so that a crystal orientation of a buildup welding is made the same as a crystal orientation of parent material crystals.

Secondly, the metal deposition method of the invention has an advantage that even when a buildup is increased in height, a temperature gradient can be ensured and control can be performed so that a direction of maximum temperature gradient is made the same as a preferential growth orientation of parent material crystals.

Thirdly, the metal deposition method of the invention has an advantage that control of temperature gradient makes it possible to control a solidification rate to restrict coarsening of dendrite.

However, this is not applied to a topmost portion of a buildup since an equiaxied structure is generated. Also, this is not applied in the case where crystals having a different orientation from a preferential growth orientation are present in a parent material, because there is possibility of growth with crystals in the different orientation as core.

Other objects, features and advantages of the present invention will become apparent from the following description of embodiments of the invention when taken in conjunction with the accompanying drawings.

### Brief Description of the Drawings

Fig. 1 is a view showing the configuration of a laser metal deposition apparatus according to a first embodiment of the invention.
Fig. 2 is a view illustrating an example of a cooling jig for indirect cooling and a method of using the same, according to the first embodiment.
Fig. 3 is a view showing the configuration of a laser metal deposition apparatus according to a second embodiment of the invention.
Fig. 4 is a view illustrating an example of a cooling jig for direct cooling with jetting of a refrigerant and a method of using the same, according to the second embodiment.
Fig. 5 is a view showing the configuration of a laser metal deposition apparatus according to a third embodiment of the invention.

### Description of the Preferred Embodiments

Embodiments according to the invention will be described hereinafter in detail.

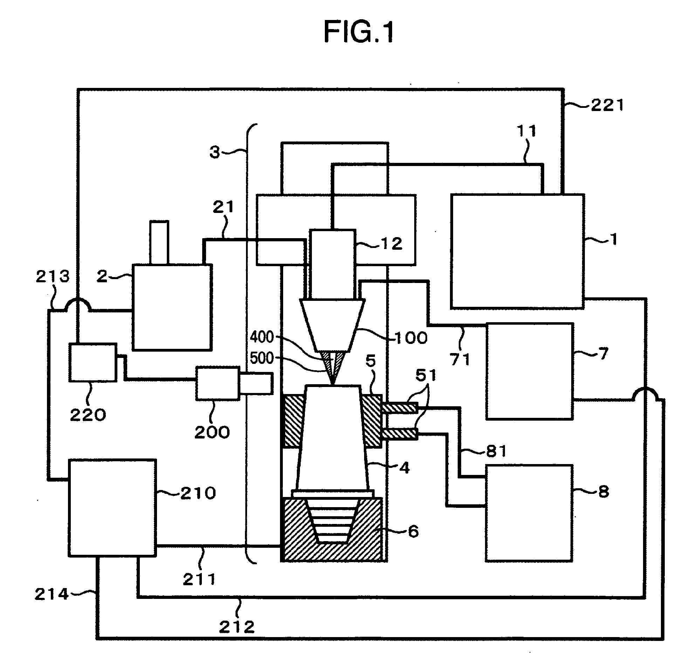

Fig. 1 shows a laser metal deposition apparatus according to a first embodiment. The reference numeral 1 denotes a laser oscillator, 11 an optical fiber, 12 a laser welding head, 2 a powder feeder, 21 a powder supply pipe, 3 a three dimensional NC processing apparatus, 4 a single crystal alloy bucket (blade), 5 a cooling jig, 51 a refrigerant inlet and outlet, 6 a bucket fixing jig, 7 a gas supply source, 71 a gas supply pipe, 8 a refrigerant supply/circulation/heat exchange apparatus, 81 a refrigerant supply pipe, 100 a powder and shielding gas supply nozzle, 200 a temperature measuring device for a processed portion, 210 a NC control board, 211 a signal conductor to the three dimensional NC processing apparatus, 212 a signal conductor to the laser oscillator, 213 a signal conductor to the powder feeder, 214 a signal conductor to the gas supply source, 220 a controller, which analyzes a temperature signal to command adjustment of laser output, and 221 a laser output adjustment signal conductor.

The laser oscillator 1, the powder feeder 2, the three dimensional NC processing apparatus 3, and the gas supply source 7 are operated in accordance with a program of the NC control board 210. Hereupon, the three dimensional NC processing apparatus is not limited in a mode of operation as in a type, in which a XY stage is used, a type, in which a robot arm is used, etc.

Laser beam 400 caused by the laser oscillator 1 to oscillate is irradiated on the single crystal alloy bucket 4 through the optical fiber 11 and through the laser head 12. Powder 500 fed from the powder feeder 2 is discharged toward a laser irradiated portion through the powder supply pipe 21 and through the powder and shielding gas supply nozzle 100 mounted on the laser head 12. The laser head 12 is mounted on the three dimensional NC processing apparatus 3 to feed powder while irradiating the laser beam and buildup welding conformed to a shape is performed by operating the laser head according to a processed shape.

A refrigerant through the refrigerant supply pipe 81 from the refrigerant supply/circulation/heat exchange apparatus 8 is caused to flow through the cooling jig 5 brought into close contact with the single crystal alloy bucket 4 whereby the bucket 4 is indirectly and forcedly cooled to beforehand give a temperature gradient. A temperature gradient is produced between a processed surface of the single crystal alloy bucket 4 and a parent material by causing the refrigerant to flow through the refrigerant inlet and outlet 51 of the cooling jig and a refrigerant flow passage 52.

Also, the laser oscillator 1 can be controlled through the signal conductor 221 by converting a temperature into a voltage value in the temperature measuring device 200 for a processed portion and issuing a command signal to decrease a laser output when the temperature is higher than a predetermined temperature and to increase a laser output when the temperature is lower than the predetermined temperature in the temperature signal analyzing device 220.

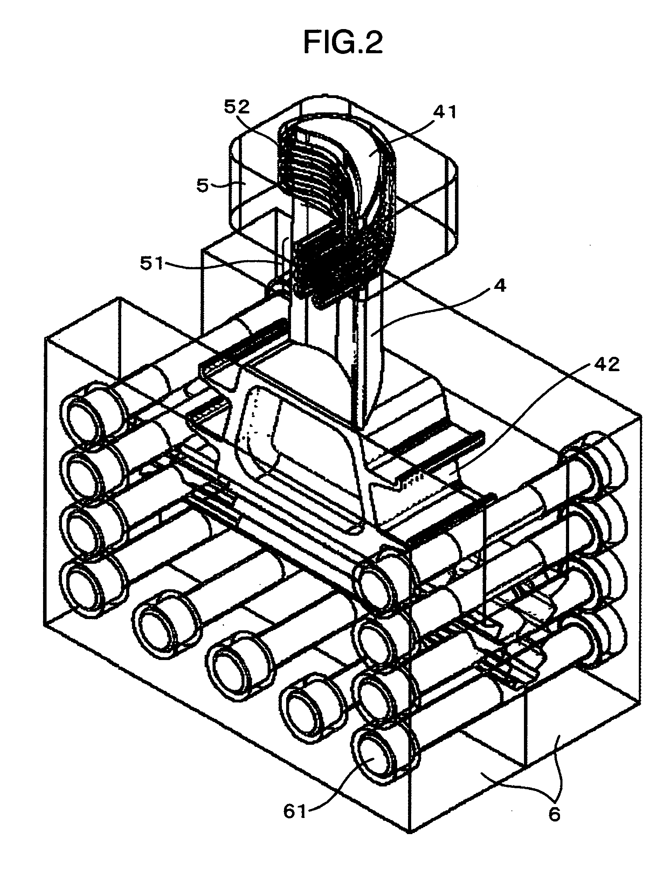

Fig. 2 shows a method of using the cooling jig 5, according to the first embodiment, for forcedly cooling at the time of laser metal deposition welding. The reference numeral 4 denotes the single crystal alloy bucket, 41 a processed surface, 42 a dovetail portion, 5 the cooling jig, 51 a refrigerant inlet and outlet, 52 a refrigerant flow passage, 6 the bucket fixing jig, and 61 a connection bolt and nut of the bucket fixing jig. The single crystal alloy bucket 4 is fixed to the bucket fixing jig 6 and the cooling jig 5 is mounted on a parent material side with respect to a processed portion to bring the same into close contact with the bucket. Hereupon, when the cooling jig 5 is arranged so as to surround a processed surface, a maximum temperature gradient is generated also in a direction perpendicular to a preferential growth orientation of parent material crystals of the single crystal alloy bucket 4, so that there is a need for mounting the cooling jig 5 on the parent material side of the single crystal alloy bucket with respect to a processed surface. A refrigerant supplied from the refrigerant supply/circulation/heat exchange apparatus 8 shown in Fig. 1 flows through the refrigerant flow passage 52 from the refrigerant inlet 51 to indirectly generate a temperature gradient between a processed surface of the single crystal alloy bucket 4 and a parent material side. The refrigerant flowing through the refrigerant flow passage 52 returns to the refrigerant supply/circulation/heat exchange apparatus 8 from the refrigerant outlet 51 and thus circulation of the refrigerant makes it possible to forcedly cool the single crystal alloy bucket.

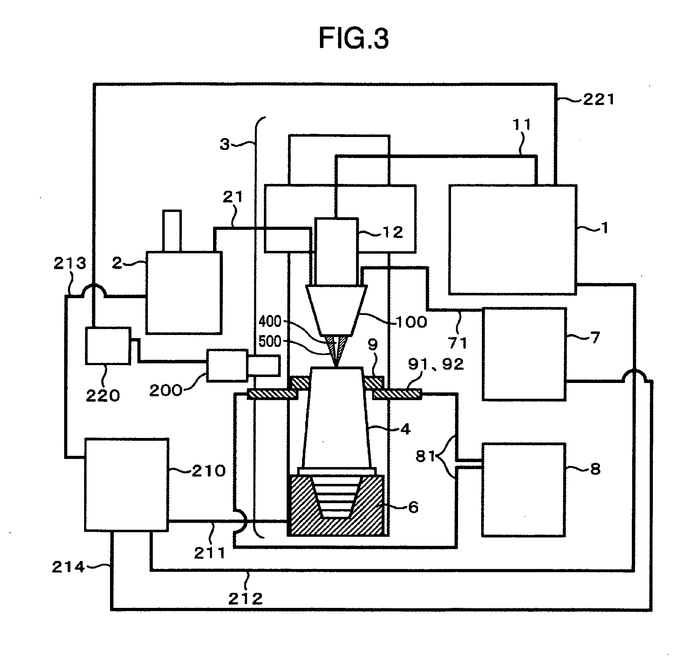

Fig. 3 shows a laser metal deposition apparatus according to a second embodiment. The apparatus is constructed such that the cooling jig 5 in the construction of the first embodiment is changed to a direct cooling jig 9.

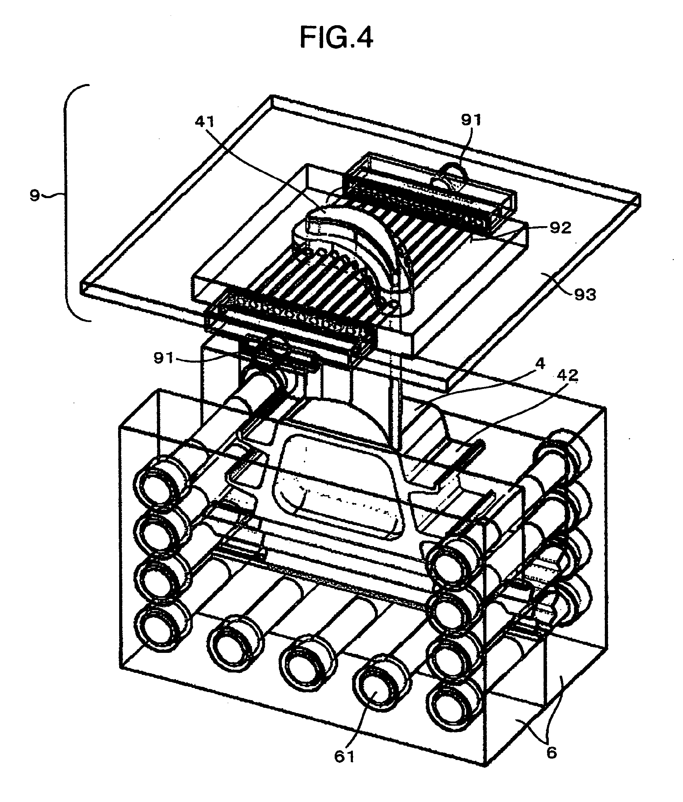

Fig. 4 shows a method of using the direct cooling jig 9, according to the second embodiment, for forcedly cooling at the time of laser metal deposition welding. The reference numeral 4 denotes the single crystal alloy bucket, 41 the processed surface, 42 the dovetail portion, 9 a direct cooling jig, 91 a refrigerant inlet, 92 a refrigerant jetting flow passage, 93 a refrigerant shielding plate, 51 the refrigerant inlet and outlet, 52 the refrigerant flow passage, 6 the bucket fixing jig, and 61 the connection bolt and nut of the bucket fixing jig. The single crystal alloy bucket 4 is fixed to the bucket fixing jig 6 and the direct cooling jig 9 is mounted on a parent material side from a processed portion to bring the same into close contact with the bucket. Hereupon, when a refrigerant is jetted so as to surround the processed surface, a maximum temperature gradient is generated also in a direction perpendicular to a preferential growth orientation of parent material crystals of the single crystal alloy bucket 4, so that there is a need for mounting the direct cooling jig 9 on the parent material side of the single crystal alloy bucket from the processed surface. A refrigerant supplied from the refrigerant supply/circulation/heat exchange apparatus 8 shown in Fig. 3 flows through the refrigerant jetting flow passage 92 from the refrigerant inlet 91 to be jetted toward the parent material side of the single crystal alloy bucket 4 from the processed surface to thereby generate a temperature gradient between the processed surface and a parent material. At this time, when the refrigerant as jetted flows onto the processed surface, it makes an obstacle to metal deposition, so that such obstacle is prevented by arranging the refrigerant shielding plate 93 in close contact with the single crystal alloy bucket 4. The direct cooling jig 9 shown in the embodiment is constructed to be provided with the refrigerant shielding plate 93.

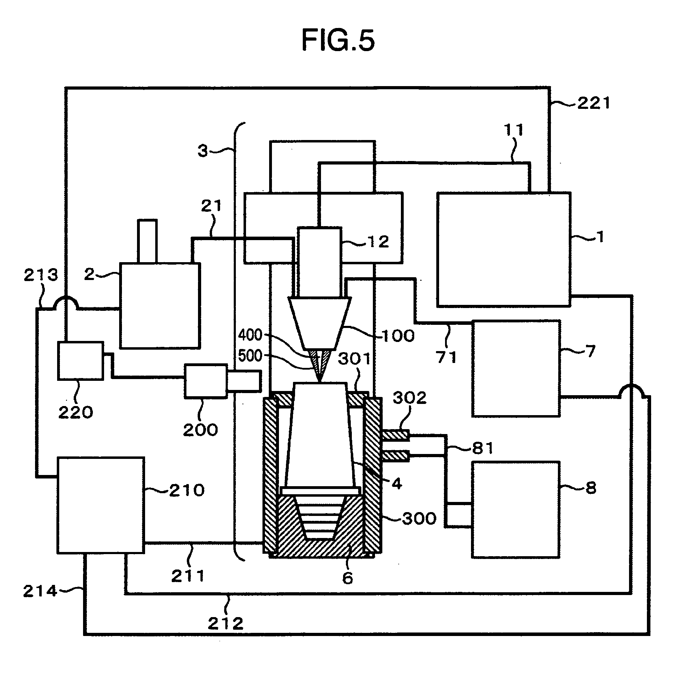

Fig. 5 shows a laser metal deposition apparatus according to a third embodiment.
The apparatus is constructed such that the cooling jig 5 in the construction of the first embodiment is changed to a refrigerant vessel 300.

A refrigerant supplied from the refrigerant supply/circulation/heat exchange apparatus 8 is introduced into the refrigerant vessel 300 from a refrigerant inlet 302 and the single crystal alloy bucket 4 fixed to the bucket fixing jig 6 is arranged in the refrigerant vessel 300 to be immersed in the refrigerant, so that the single crystal alloy bucket 4 is directly and forcedly cooled. Thereby, a temperature gradient is generated between the processed surface and the parent material. Since a maximum temperature gradient is generated also in a direction perpendicular to a preferential growth orientation of parent material crystals of the single crystal alloy bucket 4 when the single crystal alloy bucket 4 is immersed in the refrigerant so as to surround the processed surface, there is a need for arranging the refrigerant vessel 300 on a parent material side of the single crystal alloy bucket from the processed surface. Also, when the refrigerant interferes with the processed portion by evaporation of the refrigerant and a possible undulation of the refrigerant in case of mounting the refrigerant vessel to a XY stage to operate the same, it makes an obstacle to metal deposition. Therefore, such obstacle is prevented by arranging a refrigerant shielding plate 301 in close contact with the single crystal alloy bucket 4. The refrigerant returns to the refrigerant supply/circulation/heat exchange apparatus 8 from the refrigerant outlet 302 and thus circulation of the refrigerant makes it possible to forcedly cool the single crystal alloy bucket.

While a parent material side is directly cooled, metal deposition may be accomplished by providing a flow passage in a parent material and causing a refrigerant to flow through the flow passage.

In order to keep a defocusing distance constant, repeated metal deposition may be accomplished by measuring the height of a buildup immediately after build-up welding and performing a leveling processing of measurement data to determine a processing position of a succeeding layer.

It is preferable to provide a mechanism for measuring the height of a buildup immediately after build-up welding and a logic circuit mechanism for leveling processing of measurement data and to provide a logic circuit and a control unit, by which positioning is achieved so that a distance between a processing position and a laser head for laser irradiation is made a predetermined length from position information as leveled.

While the embodiments have been described, the invention is not limited thereto but it is apparent to those skilled in the art that various changes and modifications may be made within the spirit of the invention and the scope of the appended claims.

## Claims

1. A metal deposition method of forming a buildup on a single crystal or directionally solidified crystal parent material, the method **characterized by** comprising:
setting a processed surface into an up side;
cooling by means of cooling means (5; 9; 300) a portion on a parent material side with respect to the processed surface; and
depositing a metal from an extension in a preferential growth orientation of parent material crystals while beforehand giving a temperature gradient to the parent material side so that a maximum temperature gradient is oriented along the preferential growth orientation of parent material crystals.

2. The metal deposition method according to claim 1, **characterized in that** laser welding is used to repeatedly perform metal deposition to form the buildup.

3. The metal deposition method according to claim 1, **characterized in that** metal deposition is performed while indirectly cooling a parent material side by bringing a cooling jig (5), which is provided with a refrigerant flow passage, into close contact with the parent material side from the processed surface and causing a refrigerant to flow through the jig flow passage.

4. The metal deposition method, according to claim 1, **characterized in that** metal deposition is performed while directly cooling a parent material side by immersing the parent material side from the processed surface in a refrigerant, or jetting a refrigerant against the parent material side of the parent material.

5. The metal deposition method according to claim 1, **characterized in that** metal deposition is performed while directly cooling a parent material side by causing a refrigerant to flow through a flow passage in the parent material.

6. The metal deposition method according to claim 4, **characterized in that** metal deposition is performed while using a shielding mechanism (93; 301) to prevent a refrigerant from directly interfering with a processed portion.

7. The metal deposition method according to claim 3, **characterized in that** when a refrigerant used to beforehand give a temperature gradient to a parent material side is circulated, cooling is achieved to form the buildup while using a heat exchange mechanism (8) to adjust temperature of the refrigerant.

8. The metal deposition method according to claim 2, **characterized in that** in order to keep a defocusing distance constant, metal deposition is performed repeatedly by measuring the height of the buildup immediately after metal deposition and performing a leveling processing of measurement data to determine a processing position of a succeeding layer.

9. A laser metal deposition apparatus for forming a buildup on a single crystal or directionally solidified crystal parent material, the apparatus being **characterized by** comprising:
a laser welding head (12) for irradiating laser on a processed surface;
a nozzle (100) for supplying of a filler metal and shielding gases to the processed surface; and
cooling means (5; 9; 300) for forced cooling a parent material side.

10. The laser metal deposition apparatus according to claim 9, **characterized by** comprising a cooling jig (5) having a refrigerant flow passage, said cooling jig being arranged into close contact with a parent material side from the processed surface in order to indirectly and forcedly cool the parent material side by means, which causes a refrigerant to flow through the refrigerant flow passage of the cooling jig.

11. The laser metal deposition apparatus according to claim 9, **characterized by** comprising a refrigerant vessel (300) containing a refrigerant, into which a parent material side from the processed surface is immersed for directly and forcedly cooling the parent material side.

12. The laser metal deposition apparatus according to claim 9, **characterized by** comprising a cooling apparatus (9) for direct cooling of a parent material side by means (91, 92), which jets a refrigerant against the parent material side from the processed surface.

13. The laser metal deposition apparatus according to claim 11, **characterized by** further comprising a shielding mechanism (93; 301) to prevent a refrigerant from directly interfering with the processed portion.

14. The laser metal deposition apparatus according to claim 9, **characterized by** comprising an apparatus (8) for circulating the refrigerant and a mechanism (8) for adjusting temperature of the refrigerant by means of heat exchange at the time of circulation of the refrigerant.

15. The laser metal deposition apparatus according to claim 9, **characterized by** comprising a mechanism for measuring the height of the buildup immediately after metal deposition, a logic circuit mechanism for leveling processing of measurement data, and a logic circuit and a control unit, by which positioning is achieved so that a distance between a processing position and a laser head for laser irradiation is made a predetermined length from position information as leveled.
